# EUROPEAN PATENT SPECIFICATION

(11) **EP 0 500 357 B1**
(45) Date of publication and mention of the grant of the patent: **23.08.1995**
(21) Application number: 92301386.6
(22) Date of filing: 19.02.1992
(51) Int. Cl.: H04B 10/18, H01S 3/25, G02F 1/35, H01S 3/094

(54) **Optical fiber dispersion-compensating device**
Dispersionskorrekturvorrichtung für optische Faser
Compensateur de dispersion pour fibre optique

(30) Priority: 19.02.1991 JP 24233/91
(43) Date of publication of application: 26.08.1992
(73) Proprietor: NEC CORPORATION, Tokyo (JP)
(72) Inventor: Murata, Shigeru, Minato-ku, Tokyo (JP)
(74) Representative: Abnett, Richard Charles

(56) References cited:
- OPTICS LETTERS. vol. 4, no. 2, February 1979, NEW YORK US pages 52 - 54 A.YARIV ET AL 'Compensation for channel dispersion by nonlinear optical phase conjugation'
- APPLIED PHYSICS LETTERS. vol. 55, no. 6, 7 August 1989, NEW YORK US pages 519 -521 J.G. PROVOST ET AL 'Cavity enhanced highly nondegenerate four wave mixing in GaAlAs semiconductor lasers'
- ELECTRONICS LETTERS. vol. 25, no. 16, 3 August 1989, STEVENAGE, HERTS, GB pages 1053 -1055 F. FAVRE ET AL 'Contradirectional four wave mixing in 1.51 mum near travelling wave semi conductor laser amplifier'
- PATENT ABSTRACTS OF JAPAN vol. 6, no. 170 (E-128)3 September 1982 &JP-A-57 85 281 (TAKUMI TOMIJIMA)
- PATENT ABSTRACTS OF JAPAN vol. 6, no. 171 (P-140)4 September 1982 &JP-A-57 89 703 (NIPPON)
- PATENT ABSTRACTS OF JAPAN vol. 12, no. 345 (P-759)16 September 1988 & JP-A-63 103 215 (NIPPON)
- IEEE PHOTONICS TECHNOLOGY LETTERS vol. 3, no. 11, December 1991, NEW YORK USpages 1021 - 1023 S. MURATA ET AL 'THz optical frequency conversion of 1Gb/ssignals using highly nondegenerate four wave mixing in an InGaAsP semiconductor laser'

## Description

The present invention relates to an optical fiber dispersive compensating device utilizing non-degenerate four-wave mixing of a semiconductor laser.

In optical fiber communication, larger transmission speed and transmission distance of signals cause deterioration of signal waves due to frequency dispersion in the optical fiber forming the transmission path. This limits the transmission speed or distance. For example, for the transmission of a light signal at 10 Gb/s with a wavelength of 1.55 »m using an ordinary 1.3 »m zero-dispersion fiber, a limit of transmission distance due to secondary frequency dispersion is several tens km or below.

Several methods of compensating for frequency dispersion are known. From among such methods, a dispersive compensating method utilizing non-linear optical effect is one of the most useful methods since theoretically, as analysed by Yariv et al in the paper "Compensation for channel dispersion by nonlinear optical phase conjugation", in Optics Letters, Vol.4, No.2, February 1979, New York, U.S.A., it can compensate for frequency dispersion independently of transmission distance. In this method, a dispersion compensating device containing a nonlinear optical element is provided at the mid-point of a transmission path having substantially uniform frequency dispersion. In the dispersion-compensating device, a frequency conversion is performed so that the frequency spectrum of incoming signal light, which has deteriorated due to frequency dispersion, is reflected about a central frequency axis before transmission. In principle, the frequency dispersion in the second half of the transmission path thus compensates for the frequency dispersion in the first half of the transmission path. For example, assume that, due to frequency dispersing of optical fiber, higher frequency components of signal light travel faster than lower frequency components. In this process, the signal waveforms deteriorate increasingly as they propagate through the optical fiber. In the frequency conversion, lower frequency components of signal light before conversion are converted into higher frequency components. Thus, portions which are delayed on the first half of the transmission path propagate correspondingly faster on the last half of the transmission path. This compensates for the deterioration of the signal waveforms in the first half of the transmission path and effectively reconstructs the correct signal at the end of the transmission path.

Four-wave mixing or light parametric amplification are used to provide the non-linear optical frequency conversion. In this connection for example, Henmi has filed the Patent Application for a device utilizing non-degenerate four-wave mixing of a semiconductor laser amplifier (the Japanese Patent Application No. Hei 1-263678 in 1989). "Non-degenerate four-wave mixing" means the phenomenon that, when pump light of frequency λ and probe light of frequency λ+Δλ (here, corresponding to input signal light) are simultaneously incident on a non-linear optical medium, a light signal of λ-Δλ is output. If the probe light comprises a spectrum having a range of frequencies, the output light frequency distribution is thus a reflection of the probe light frequency distribution about the pump light frequency.

The non-degenerate four-wave mixing of a semiconductor laser or a semiconductor laser amplifier can be produced by two different mechanisms. The first is due to carrier density modulation, wherein frequency conversion efficiency is higher but frequency response is limited by life time (about 1 ns) of a carrier. Therefore, the highest signal light frequency which can be converted is as low as about 1 Gb/s. The second mechanism is due to introband non-linear process, having lower efficiency of frequency conversion but exhibiting faster response of several hundreds GHz or more. Therefore signals with 100 Gb/s or more may theoretically be converted. This second mechanism has a much lower efficiency of frequency conversion than the first. Consequently the first mechanism is widely used in conventional examples.

A number of problems arise in the conventional examples hereinbefore described. Disadvantageously, in order to utilize non-linear optical effect such as the four-wave mixing or the light parametric amplification, a relatively powerful pump light source is generally needed. For example, utilization of optical fiber as non-linear optical medium requires a pump light source of several watts or above. For this reason, relatively large devices like solid state laser devices are required for dispersion-compensating devices. These are difficult to use in optical fiber transmission in view of their power consumption and stability. The very large pump light source output is necessary because there is no non-linear optical medium with higher efficiency capable of operating with a lower output pump light source such as one of several tens mW or below.

The only known solution to this problem is to use the non-degenerate four-wave mixing of the semiconductor laser amplifier as in the conventional example described above. This requires a pump light source with 1 mW or below to obtain an adequate efficiency of frequency conversion. However, because the four-wave mixing caused by modulation of carrier density as conventionally used has lower speed response, high frequency signals of 1 Gb/s or above are difficult to frequency convert. If the four-wave mixing caused by the introband non-linear process could be used, a higher frequency signal could be converted.

Because the conversion efficiency is much lower however, a dispersive compensating device utilizing such phenomenon has not been realized to date.

The phenomenon of non-degenerate four wave mixing (NDFWM) using an introband process, i.e. the modulation of the occupation probability of carriers within a band, has however been observed experimentally as described by Provost and Frey, in "Cavity-enhanced highly non-degenerate four-wave mixing in GaAlAs semiconductor lasers", Applied Physics Letters, vol.55, no.6, 7th August 1989, New York, U.S.A. In this experiment a GaAlAs semiconductor laser was used as the non-linear optical medium. Pump light was provided simply by operating the laser in conventional fashion and a probe beam was input from a laser diode. The spectral characteristics of the output beam from the GaAlAs laser were analysed and the pump frequency ω, the probe frequency ω+Δω and a conjugate frequency ω-Δω were identified, thus demonstrating that NDFWM had occurred.

The invention provides an optical fibre dispersion-compensation device as defined in the appendant independent claim. Preferred features of the invention are defined in dependent subclaims.

The present invention may thus advantageously provide an optical fibre dispersion-compensating device exhibiting stability with lower power consumption capable of compensating waveform deterioration caused by frequency dispersion of high speed signals with several Gb/s or above.

Non-degenerate four-wave mixing in a semiconductor laser or a semiconductor laser amplifier can be produced by two different mechanisms. One mechanism is due to carrier density variation, wherein the maximum light signal transmission frequency which can be converted is as low as about 1 GHz. Another mechanism is due to an introband non-linear process, and has lower efficiency but exhibits a response time enabling conversion at several hundreds GHz or above.

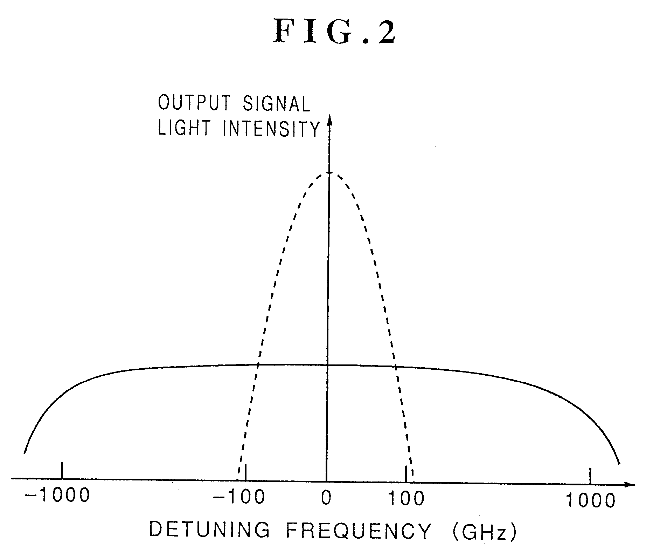

The utilization of introband non-linear process of the semiconductor laser which has not previously been used for optical fibre dispersion-compensation makes possible dispersion-compensation of high frequency light signals with several Gb/s or above. FIG. 2 indicates a typical detuning frequency dependency of the output signal light intensity in a non-degenerate four-wave mixing process in a travelling wave type semiconductor laser amplifier. "Detuning frequency" means a difference between input signal light frequency and pump light frequency. The effect caused by modulation of carrier density is shown by dotted line and the effect caused by the introband non-linear process is shown by solid line. In the latter, the output signal light intensity is substantially constant in the frequency range from one hundred GHz to several hundreds GHz, whereas in the former the values at several hundreds of GHz are negligible. Therefore, if the frequency distribution, or spectrum of input signal light is reflected using four-wave mixing in the range of the detuning frequency, frequency conversion of high frequency signals of 100 Gb/s or above can theoretically be achieved and dispersion-compensation becomes possible.

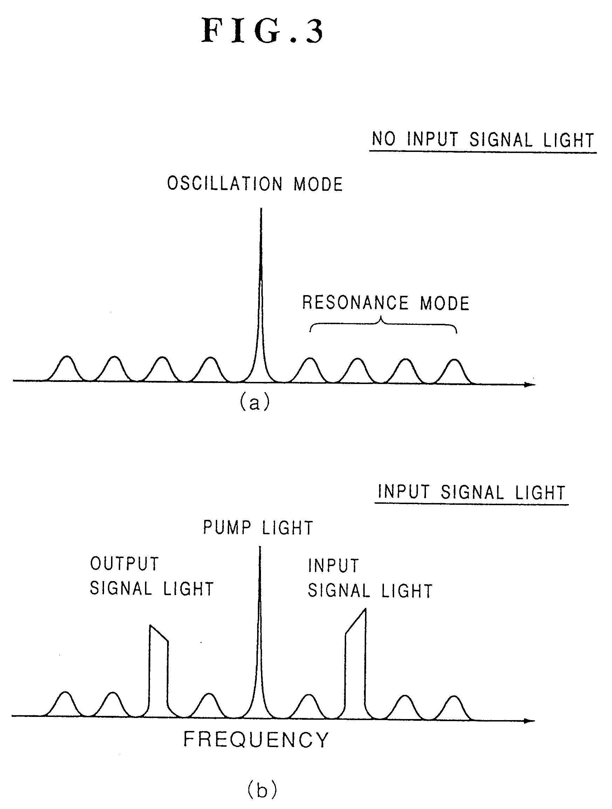

A specific method will be explained referring to FIG. 3 which typically indicates resonance modes, pump light, input signal light, and output light relating to frequencies with respect to a Fabry-Perot type semiconductor laser (FP laser). The resonance modes are aligned substantially at even intervals on a frequency axis as in FIG. 3(a). Frequency of pump light is matchable to be injected into one of the resonance modes of the semiconductor laser, so that only that resonance mode of the semiconductor laser is emphasized and the laser oscillates in a single axis mode (this means the forming of injection locking status). Here, frequency of the input signal light is matchable to be injected into one of the other resonance modes. The output signal light frequencies are then formed by frequency conversion by reflection of the input light frequencies to the position of a resonance mode exactly symmetrical to the pump light frequency as in FIG. 3(b), being generated by the process of the non-degenerate four-wave mixing in which the oscillating light is used as pump light and the input signal light is used as probe light. The output signal light is amplified by an order of magnitude or more by resonance, resulting in higher intensity. In the utilization of resonance as in the present invention, in addition to amplification of the output signal light, the four-wave mixing may advantageously be generated at a relatively lower power due to an internal electric field enlarged by confining the pump light and input signal light into a resonator. The arrangement using the semiconductor laser as non-linear optical medium provides a smaller size with stable operation.

Although the resonance modes to be used must be within a gain-band of the semiconductor laser, limitation for a frequency band to be used is slack due to an ordinary gain band of several thousands GHz. The maximum value of detuning frequency, that is, the resonance mode frequency furthest from the pump light frequency to be used must be selected to be about 1000 GHz or less from the pump light frequency.

This value is determined depending on response time of the introband non-linear process of the semiconductor laser. The minimum value of detuning frequency is determined by frequency interval of the resonance modes (usually about 100 to 200 GHz), which frequency interval is inversely proportional to length of resonator of the semiconductor laser and may be adjusted by suitably setting the resonator length. The output signals are amplified using resonance according to the invention, and hence limitation of frequency band due to resonance determines the upper limit of signal speed to be dispersion-compensated. For this band, the resonator length of the semiconductor laser, end surface reflectivity and inside gain are adjustable to obtain a band of the order of several tens GHz, and capable of compensating frequency dispersion of higher speed signals of about 10 Gb/s.

The spectrum of output signal light is in the form where the spectrum of input signal light is reflected with respect to the frequency of the pump light. Accordingly, influence of frequency dispersion of a transmission path on the transmitting side is compensated on the receiving side. The dispersion-compensating device containing this non-linear optical medium may thus be arranged at the intermediate position of an optical fiber transmission path having substantially uniform frequency dispersion characteristic and the output signal light after spectrum reflection transmitted to the receiving side. From this process, a signal wave-form may be received at the receiving end of the transmission path substantially without suffering deterioration by frequency dispersion. In this device, the output signal light has a center frequency different by several hundreds GHz from that of the input light. However, such problem is avoided on the transmission path by some positional adjustment of the location of the dispersion-compensating device. More specifically, the dispersion-compensating device may preferably be arranged at the position where a total of dispersion at center frequency of input signal light of the transmission path on the transmitting side may be equal to the total of dispersion at center frequency of output signal light on the receiving side of the transmission path.

Preferred embodiments of an optical fiber dispersive compensating device in accordance with the present invention will hereinafter be described in detail with reference to the accompanying drawings.

FIG. 1 is a block diagram of a first embodiment of an optical fiber dispersion-compensating device according to the present invention.

FIG. 2 is a diagram showing detuning frequency dependency of output signal light intensity on process of non-degenerate four-wave mixing.

FIG. 3 is a diagram showing a resonance mode, pump light, input signal light, and output signal light relating to frequency with respect to an FP laser.

FIG. 4 is a diagram showing output spectra for pump light, input signal light, and output signal light relating to frequency with respect to a distributed feedback type semiconductor laser (DFB laser).

FIG. 5 is a block diagram-of a second embodiment of an optical fiber disperson-compensating device according to the present invention.

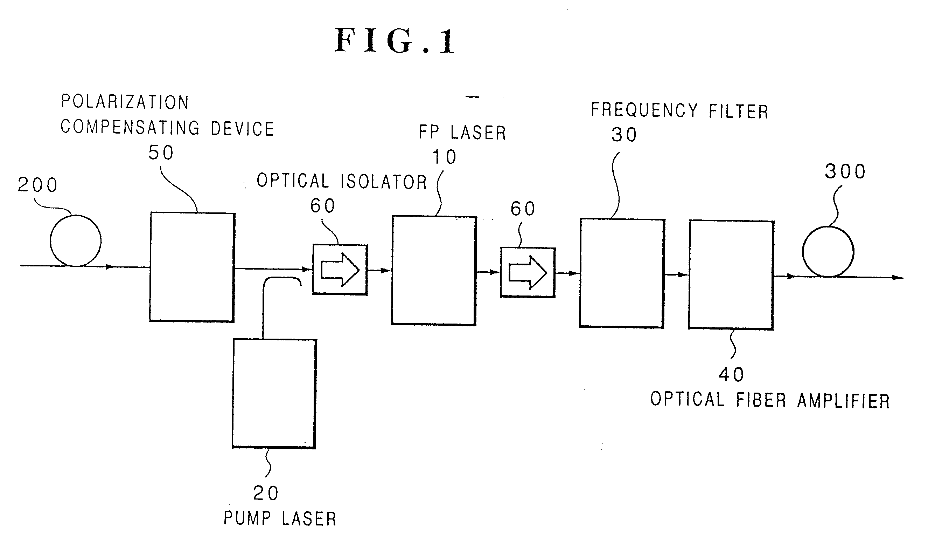

FIG. 1 is a block diagram of a first embodiment according to the present invention, typically showing a basic construction of an optical fiber dispersion-compensating device. The optical fiber dispersion-compensating device is essentially comprised of a Fabry-Perot type semiconductor laser (FP laser) 10 of non-linear optical medium, a pump laser 20, a frequency filter 30, an optical fiber amplifier 40, a polarization compensating device 50, an optical isolator 60, and an optical system for connection thereof. A spectrum of input signal light deteriorated by frequency dispersion from a transmission line 200 on the transmitting side is reflected (in other words, frequency converted) about a frequency axis using non-degenerate four-wave mixing of an FP laser 10 and is fed as output signal light to a transmission line 300 on the receiving side. The operational principle is as hereinbefore described.

A semiconductor laser with 1.55 »m band is used as an FP laser 10, a distributed feedback type semiconductor laser (hereinafter referred to as a DFB laser) with 1.55 »m band is used as a pump laser 20. Both of the two lasers are temperature stabilized within ±0.1 °C or less. A resonance mode of the FP laser 10 and frequency of the pump laser 20 are respectively adjusted by temperature control. Frequency of output signal light may be changed with variation of frequency of pump laser 20 and with variation of an oscillation mode of the FP laser 10. The frequency filter 30 is for taking up only output signal light from the FP laser 10 and in this arrangement a Fabry-Perot interference type filter is used therefor. The optical fiber amplifier 40 is one for amplifying a converted output signal light to deliver it to a transmission line. The optical fiber amplifier 40 uses erbium doped optical fiber by semiconductor laser excitation. The polarization compensating device 50 is to apply pressure to optical fiber to adjust polarization of input signal light and is comprised of a stress applying section, a monitor section, a control section and the like.

The non-linear optical medium may also be provided by a semiconductor laser with a plurality of resonance modes capable of single axis mode oscillation.

Such lasers may include an ordinary FP laser or the DFB laser, a distributive Bragg reflection type semiconductor laser, a composite resonance type semiconductor laser and the like.

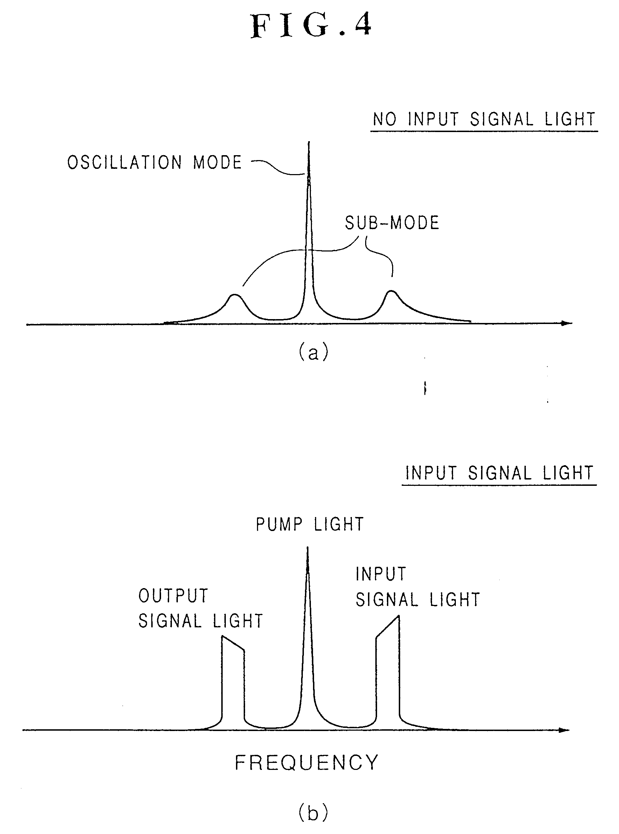

FIG. 4 is a diagram showing typical output spectra in use of a DFB laser, and more particularly showing pump light, input signal light, and output signal light each relating to frequency. A so-called λ/4 shift type DFB laser is used as a DFB laser. In this λ/4 shift type DFB laser, a sub-mode is present at the symmetrical positions on both sides of a central oscillation mode as in FIG. 4(a). The signal light at the positions of the sub-modes are amplified by resonance as in a resonance mode of the Fabry-Perot type. When the input signal is injected to a position of one of the sub-modes in the oscillation state, output signal light with a spectrum reflected about a frequency axis to the position of a sub-mode on the opposite side of the pump light (that is, oscillation light) as shown in Figure 4(b) is generated by non-degenerate four-wave mixing. This output signal light is amplified by resonance, thus producing great intensity. A frequency interval of the oscillation mode and the sub-mode is normally about 100 to 200 GHz or above, and only the output signal light may be taken out by the frequency filter 30. A resonance frequency band may be adjusted by varying resonator length or a coupling coefficient of diffraction grating of the λ/4 shift type DFB laser , and its frequency band is in the order of several tens GHz.

The λ/4 shift type DFB laser is ordinarily non-reflectively coated at both ends. However, if it has a several percent reflectivity, a resonance mode as in the FP laser arises on both sides of sub-modes as shown in FIG. 4. This indicates a possibility to use these resonance modes. The same results are obtained even in using as a single mode laser the semiconductor laser having the other construction as hereinbefore described.

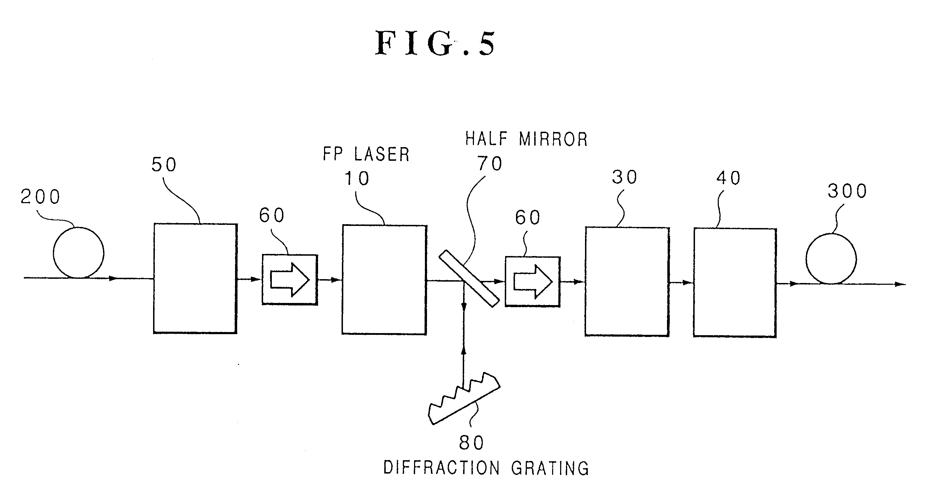

FIG. 5 is a block diagram of the second embodiment according to the present invention.

An essential different point from the first embodiment is to provide a means for single axis mode oscillating by selective feedback of light of specific resonance mode from among a plurality of resonance modes using an FP laser 10 as non-linear optical medium. The other points are substantially the same as the first embodiment. In the device, light itself of the oscillation mode may be used as pump laser thereby the pump light as arranged in the first embodiment is not necessary. Thus the device construction is simplified. The operational principle is entirely the same as the first embodiment. A diffraction grating 80 is used as a means for feeding-back a specific resonance mode. A half mirror 70 is introduced for taking out an output signal light from the FP laser 10.

While the preferred embodiment in accordance with the present invention has fully been described, some supplemental explanation will be made as follows. In the embodiments, only the device corresponding to 1.55 »m band as a wavelength band of signal light has been shown and described. However, by varying the wavelength of the semiconductor laser and pump light source, the same effect as hereinbefore described may be obtained even for signal light of other wavelength bands for example, 1.3 »m band etc. The device according to the present invention may effectively be applied as a modulation and demodulation system of signal light not only in a direct detecting system but also in the other method such as a coherent system. The frequency filter 30 and the fiber amplifier 50 of the embodiments may be omitted depending on a transmission line. The polarized wave compensating device 50 is not necessary in the arrangement where a polarization maintained optical filter is used as a transmission line or in the transmission line where a polarization variation is negligible.

In the arrangement capable of amplifying by resonance according to the present invention, the output signal light may be taken out from any of two resonator faces of semiconductor laser of non-linear optical medium. Therefore, in addition to the arrangement according to the embodiments, for example, the arrangement capable of injecting the pump light and input signal light from an output side resonator face may be utilized by suitably changing an optical system.

As hereinbefore fully described according to the present invention, there may be realized an optical fiber dispersion-compensating device of stability with lower electric power consumption capable of compensating wave deterioration due to dispersion of high speed signals with several Gb/s or above.

## Claims

1. An optical fibre dispersion-compensation device comprising a non-linear optical medium (10) having a plurality of resonance modes, provided by a semiconductor laser, an injection means for injecting input signal light into the non-linear optical medium, a take-out means (30) for taking out from the non-linear optical medium output signal light generated by frequency conversion of the input signal light in the non-linear optical medium by non-degenerate four-wave mixing, and a variable-frequency pump means (20), (70,80) coupled to the non-linear optical medium for establishing oscillation of the non-linear optical medium at a frequency substantially coincident with a resonance mode thereof, the frequency of the input signal light being substantially coincident with a resonance mode different from the established oscillation frequency.

2. A device according to claim 1, in which the pump means comprises a semiconductor laser for injecting pump light into the non-linear optical medium.

3. A device according to claim 2, in which the pump means semiconductor laser is a distributed feedback type semiconductor laser.

4. A device according to claim 1, in which the pump means comprises a means for feeding back to the non-linear optical medium light of a frequency substantially corresponding to a resonance mode of the non-linear optical medium.

5. A device according to claim 4, in which the selective feedback means comprises a diffraction grating (80).

6. A device according to any preceding claim, in which the non-linear optical medium is provided by a Fabry-Perot-type semiconductor laser in which single axis mode oscillation in a specific resonance mode of the laser from among a plurality of resonance modes of the laser is established by the variable frequency pump means.

7. A device according to any preceding claim, in which the non-linear optical medium is temperature stabilised within ± 0.1°C or less.

8. A device according to claim 2, in which the pump means semiconductor laser is temperature stabilised to within ±0.1°C or less.

## Patentansprüche

1. Dispersionskorrekturvorrichtung für Lichtwellenleiter mit einem nichtlinearen optischen Medium (10) mit mehreren Resonanzmoden, gebildet durch einen Halbleiterlaser, einer Injektionseinrichtung zum Injizieren von Eingabesignallicht in das nichtlineare optische Medium, einer Abnahmeeinrichtung (30) zum Abnehmen von Ausgabesignallicht, das durch Frequenzwandlung des Eingabesignallichts in dem nichtlinearen optischen Medium durch nichtentartete Vierwellenmischung erzeugt wird, von dem nichtlinearen optischen Medium sowie einer mit dem nichtlinearen optischen Medium gekoppelten Pumpeinrichtung (20), (70, 80) mit veränderlicher Frequenz zum Herstellen einer Schwingung des nichtlinearen optischen Mediums mit einer Frequenz, die im wesentlichen mit einer Resonanzmode von ihr zusammenfällt, wobei die Frequenz des Eingabesignallichts im wesentlichen mit einer Resonanzmode zusammenfällt, die sich von der hergestellten Schwingungsfrequenz unterscheidet.

2. Vorrichtung nach Anspruch 1, wobei die Pumpeinrichtung einen Halbleiterlaser zum Injizieren von Pumplicht in das nichtlineare optische Medium aufweist.

3. Vorrichtung nach Anspruch 2, wobei der Halbleiterlaser der Pumpeinrichtung ein Halbleiterlaser mit verteilter Rückkopplung (DFB-Laser) ist.

4. Vorrichtung nach Anspruch 1, wobei die Pumpeinrichtung eine Einrichtung zum Rückkoppeln von Licht mit einer Frequenz, die im wesentlichen einer Resonanzmode des nichtlinearen optischen Mediums entspricht, zu dem nichtlinearen optischen Medium aufweist.

5. Vorrichtung nach Anspruch 4, wobei die selektive Rückkopplungseinrichtung ein Beugungsgitter (80) aufweist.

6. Vorrichtung nach einem der vorhergegangenen Ansprüche, wobei das nichtlineare optische Medium durch einen Fabry-Perot-Halbleiterlaser gebildet ist, in dem eine Einachsenmodenschwingung in einer spezifischen Resonanzmode des Lasers von mehreren Resonanzmoden des Lasers durch die Pumpeinrichtung mit veränderlicher Frequenz hergestellt wird.

7. Vorrichtung nach einem der vorhergegangenen Ansprüche, wobei das nichtlineare optische Medium innerhalb von höchstens ± 0,1 °C temperaturstabilisiert ist.

8. Vorrichtung nach Anspruch 2, wobei der Halbleiterlaser der Pumpeinrichtung innerhalb von höchstens ± 0,1 °C temperaturstabilisiert ist.

## Revendications

1. Dispositif de compensation de dispersion de fibre optique comprenant un milieu optique non linéaire (10) présentant une multitude de modes de résonance, muni d'un laser à semi-conducteur, un moyen d'injection pour injecter le signal lumineux en entrée dans le milieu optique non linéaire, un moyen de sortie (30) pour sortir du milieu optique non linéaire le signal lumineux produit par conversion en fréquence du signal lumineux d'entrée dans le milieu optique non linéaire par mélange quatre ondes non dégénérées, et un moyen de pompage à fréquence variable (20), (70,80) couplé au milieu optique non linéaire afin d'établir l'oscillation du milieu optique non linéaire à une fréquence qui coïncide pratiquement avec son mode de résonance, la fréquence du signal lumineux en entrée coïncidant pratiquement avec un mode de résonance différent de la fréquence d'oscillation établie.

2. Dispositif selon la revendication 1, dans lequel le moyen de pompage comprend un laser à semi-conducteur destiné à injecter la lumière de pompage dans le milieu optique non linéaire.

3. Dispositif selon la revendication 2, dans lequel le laser à semi-conducteur du moyen de pompage est un laser à semi-conducteur du type à réaction répartie.

4. Dispositif selon la revendication 1, dans lequel le moyen de pompage comprend un moyen pour renvoyer au milieu optique non linéaire un signal lumineux d'une fréquence correspondant pratiquement à un mode de résonance du milieu optique non linéaire.

5. Dispositif selon la revendication 4, dans lequel le moyen de réaction sélectif comprend un réseau de diffraction (80).

6. Dispositif selon l'un quelconque des revendications précédentes, dans lequel le milieu optique non linéaire est prouvé par un laser à semi-conducteur du type Fabry-Perot dans lequel l'oscillation monomode axiale dans un mode de résonance spécifique laser parmi une multitude de modes de résonance du laser est établie par le moyen de pompage à fréquence variable.

7. Dispositif selon l'une des quelconques revendications précédentes, dans lequel le moyen optique non linéaire est stabilisé en température à l'intérieur d'une plage de ± 0,1°C ou moins.

8. Dispositif selon la revendication 2, dans lequel le laser à semi-conducteur du moyen de pompage est stabilisé en température à l'intérieur d'une plage de ± 0,1°C ou moins .
